# FASCICULE DE BREVET EUROPEEN

(11) **EP 2 422 206 B1**
(45) Date de publication et mention de la délivrance du brevet: **18.09.2013**
(21) Numéro de dépôt: 10714000.6
(22) Date de dépôt: 20.04.2010
(51) Int. Cl.: G01R 31/317

(54) **DISPOSITIF DE SURVEILLANCE DU FONCTIONNEMENT D'UN CIRCUIT NUMERIQUE**
EINRICHTUNG ZUM ÜBERWACHEN DES BETRIEBS EINER DIGITALEN SCHALTUNG
DEVICE FOR MONITORING THE OPERATION OF A DIGITAL CIRCUIT

(30) Priorité: 20.04.2009 FR 0952560
(43) Date de publication de la demande: 29.02.2012
(73) Titulaire: Commissariat à l'Énergie Atomique et aux Énergies Alternatives, 75015 Paris (FR)
(72) Inventeur: REBAUD, Bettina, F-73200 Gilly Sur Isere (FR); BELLEVILLE, Marc, F-38120 Saint-Egreve (FR); MAURINE, Philippe Lionel, F-30260 Quissac (FR)
(74) Mandataire: Lebkiri, Alexandre
(86) Numéro de dépôt international: PCT/EP2010/055222
(87) Numéro de publication internationale: WO 2010/122036

(56) Documents cités:
- US-A1- 2006 119 397
- DAS S ET AL: "RazorII: In Situ Error Detection and Correction for PVT and SER Tolerance" IEEE JOURNAL OF SOLID-STATE CIRCUITS, IEEE SERVICE CENTER, PISCATAWAY, NJ, US, vol. 44, no. 1, 1 janvier 2009 (2009-01-01), pages 32-48, XP011241059 ISSN: 0018-9200
- KALISZ J ET AL: "Dual-edge late-transition detector for testing the metastability effect in flip-flops" MICROELECTRONICS, 2004. ICM 2004 PROCEEDINGS. THE 16TH INTERNATIONAL C ONFERENCE ON TUNIS, TUNISIA DEC. 6-8, 2004, PISCATAWAY, NJ, USA,IEEE LNKD- DOI:10.1109/ICM.2004.1434782, 6 décembre 2004 (2004-12-06), pages 780-782, XP010800934 ISBN: 978-0-7803-8656-3
- SATISH YADA ET AL: "Modified Stability Checking for On-line Error Detection" VLSI DESIGN, 2007. HELD JOINTLY WITH 6TH INTERNATIONAL CONFERENCE ON E MBEDDED SYSTEMS., 20TH INTERNATIONAL CONFERENCE ON, IEEE, PI, 1 janvier 2007 (2007-01-01), pages 787-792, XP031044498 ISBN: 978-0-7695-2762-8 cité dans la demande
- MRIDUL AGARWAL ET AL: "Optimized Circuit Failure Prediction for Aging: Practicality and Promise" TEST CONFERENCE, 2008. ITC 2008. IEEE INTERNATIONAL, IEEE, PISCATAWAY, NJ, USA, 28 octobre 2008 (2008-10-28), pages 1-10, XP031372401 ISBN: 978-1-4244-2402-3 cité dans la demande

## Description

La présente invention a pour objet un dispositif de surveillance, d'observation du fonctionnement d'un circuit numérique. Elle a pour but essentiel d'anticiper et /ou de détecter, lors du fonctionnement du circuit numérique considéré, les signaux violant les contraintes temporelles, notamment les contraintes temporelles liées aux temps d'établissement et aux temps de maintien des éléments mémoires de types bascule ou verrou.

Le domaine de l'invention est, d'une façon générale, celui des circuits électroniques numériques. De tels circuits utilisent une horloge, générant un signal d'horloge à une fréquence préalablement déterminée, dite fréquence d'horloge, pour cadencer les transferts de données, notamment entre des éléments séquentiels de type bascule ou verrou (latch dans la littérature anglaise). Afin d'améliorer les performances temporelles des circuits numériques, on peut chercher à utiliser une fréquence d'horloge la plus élevée possible.

Aussi, dans les circuits électronique numériques, un certain nombre de vérifications, dites vérifications temporelles, doivent être effectuées pour s'assurer que ledit circuit respecte les contraintes de performances, et plus spécifiquement pour vérifier que le circuit reste fonctionnel à la fréquence d'horloge préconisée. Ces vérifications sont réalisées par le calcul des temps de propagation sur les chemins de données et d'horloge du circuit, en s'assurant que les contraintes de temps de maintien et d'établissement des bascules/verrous d'arrivées ne sont pas violées - on parle de violations temporelles - , et cela sur l'ensemble du circuit. Le temps d'établissement d'une bascule/verrou correspond au temps de stabilité minimum qu'une donnée doit respecter en entrée de la bascule avant que ne se présente le front d'horloge, afin qu'elle soit effectivement prise en compte par la bascule/ le verrou. Le temps de maintien d'une bascule/verrou correspond au temps de stabilité minimum qu'une donnée doit respecter en entrée de la bascule/verrou après que le front d'horloge s'est présenté, afin que ladite donnée soit effectivement prise en compte par la bascule/verrou.

Dans les technologies micrométriques, les analyses de type pire-cas permettent d'identifier les chemins critiques limitant la fréquence de fonctionnement du circuit et d'estimer de façon réaliste les temps de propagation dans ces chemins..Les chemins critiques correspondent dans la pratique aux chemins susceptibles d'être empruntés par un signal, et pour lesquels les risques de violations temporelles sont les plus probables. La marge temporelle (slack) est définie comme la différence entre le temps d'arrivée escompté du signal et le temps d'arrivée induisant une violation de la contrainte.

Dans le cadre de la conception de circuits en technologie nanométriques, et plus particulièrement de circuits faible consommation, les marges prises lors des analyses pire-cas deviennent très pessimistes à tel point que le circuit ne peut pas être optimisé de façon efficace. En effet, les variations de processus de fabrication, les variations environnementales-telles que les baisses locales et temporaires de la tension d'alimentation -, ou encore l'apparition de gradients de température, sont d'autant de phénomènes dont l'impact sur les performances des circuits nécessite la prise en compte de marges temporelles de plus en plus grandes pour être certain de couvrir toutes les éventualités si les méthodes d'analyses actuelles sont appliquées.

Les variations dynamiques des performances temporelles, dues aux variations dynamiques difficilement prévisibles de température et de tension d'alimentation rendent indispensables le suivi en ligne des performances du circuit en intégrant au sein même du circuit des éléments pouvant détecter ces dérives et pouvant trouver le point de fonctionnement optimal du circuit en réduisant au mieux les marges temporelles introduites par l'utilisation des méthodes d'analyse des délais actuelles.

Dans un premier temps, le suivi en ligne des performances du circuit numérique peut se faire grâce à l'intégration d'oscillateurs en anneau ou des répliques de chemins critiques pour connaitre la fréquence maximum de fonctionnement. Mais ces capteurs, consommant, de surface importante et difficiles à exploiter, ne couvrent que les variations globales du circuit et la présence de variations locales rendent insuffisantes leur mise en oeuvre,.

Pour prendre en compte les variations locales, une autre solution pour réaliser le suivi en ligne des performances consiste à proposer un système intégré dans la fonctionnalité même du circuit. Dans le document : « Das, S et al. « A self-tuning DVS processor using delay-error detection and correction », IEEE_JSSC, 2006, 41, 792-804 », des bascules appelées bascules RAZOR permettent de détecter une violation de temps d'établissement en utilisant de la redondance au niveau des éléments séquentiels, de type bascule notamment. Néanmoins, cette solution comporte plusieurs problèmes : afin d'avoir un taux de couverture sur chemins critiques acceptable, il convient de minimiser l'impact de l'insertion de cette redondance, or les bascules RAZOR occupent deux à trois plus de surface silicium que des bascules standards et consomment nettement plus. Une autre méthode, basée sur la vérification de la stabilité des données, s'appuie sur une structure matérielle de vérification dont le rôle est de comparer entrée et sortie de bascules pour détecter d'éventuelles violations temporelles. Une telle méthode est par exemple décrite dans le document suivant : "Yada et al. "Modified Stability Checking for On-line Error Detection" proceedings of VLSID'07, 20th International Conference on VLSI Design, 2007".

Si cette méthode a le mérite de réduire considérablement le coût en terme de surface silicium, notamment par rapport à la solution consistant à utiliser des bascules RAZOR, les fenêtres temporelles de détection d'erreur caractérisant les structures de vérifications, sont malheureusement dans les deux exemples fixes et trop larges. Ainsi, un problème apparait alors : si, entre une premier élément séquentiel et un deuxième élément séquentiel on a identifié un chemin critique, et qu'il existe un autre chemin plus court entre un autre élément séquentiel (ou éventuellement entre le premier élément séquentiel) et le dit deuxième élément séquentiel ; il est alors nécessaire de rajouter sur ce chemin plus court un certain nombre de cellules de délais-ou buffers - ralentissant la propagation du signal entre les deux éléments séquentiels considérés, pour éviter les violations de temps de maintien de l'élément séquentiel d'arrivée lorsque le signal emprunte ledit chemin plus court. Par ailleurs, l'insertion de ces structures n'est possible que dans des architectures comportant un module de rattrapage, c'est-à-dire un module de correction d'erreur, par exemple en ré-exécutant à une fréquence plus faible la séquence mise en faute. C'est la raison pour laquelle cette approche cible - principalement les microprocesseurs hautes performances à fort débit de calculs.

Le document « Agarwal et al. « Optimized Circuit Failure Prediction for Aging Practicality and Promise", International Test conference Oct 08" propose un système plus léger que RAZOR, permettant d'anticiper les fautes et donc d'éviter l'insertion d'un module de rattrapage. Cependant, son implémentation est telle que la largeur de la fenêtre d'anticipation est hautement corrélée aux conditions environnementales du circuit, ce qui pose des problèmes de marges variant en cas de recherche de point optimal (Tension, fréquence).

Le dispositif de surveillance selon l'invention propose une solution aux problèmes et inconvénients qui viennent d'être exposés. Dans l'invention, on propose une solution pour anticiper et/ou détecter, et ce lors du fonctionnement du circuit, les signaux violant les contraintes temporelles. A cet effet, on prévoit, dans l'invention, la génération d'une fenêtre temporelle, générée à partir du signal d'horloge du circuit numérique considéré, dont la durée et la récurrence sont déterminées de manière précise ; dans l'invention, on prévoit également une utilisation efficace de l'arbre d'horloge déjà disponible dans les circuits numériques à logique utilisant notamment des bascules/verrous comme éléments d'échantillonnage des données. D'une manière générale, le dispositif selon l'invention permet ainsi d'anticiper et de détecter les violations de temps d'établissement et de maintien dues aux variations dynamiques par le positionnement d'une fenêtre temporelle précédant l'arrivée du front du signal d'horloge ; le dispositif selon l'invention permet également, pour un circuit numérique considéré, de caractériser les variations statiques (qualité du circuit défini par la donnée, après fabrication, de l'ensemble des paramètres caractérisant la technologie avec laquelle il a été conçu) et/ou dynamiques (vieillissement des composants, variations de la tension d'alimentation, de la température, ou toute autre variation intervenant de manière temporaire durant la durée de vie du circuit et affectant les performances temporelles du circuit) dudit circuit numérique, notamment en déterminant les fréquences du signal d'horloge maximales de fonctionnement.

L'invention concerne donc essentiellement un circuit électronique numérique comprenant :
- une pluralité d'éléments séquentiels ;
- au moins un chemin conducteur de données reliant un élément séquentiel d'entrée à un élément séquentiel de destination ;
- une horloge délivrant un signal d'horloge sur un arbre d'horloge pour cadencer les éléments séquentiels ;
   caractérisé en ce qu'il comprend un dispositif de surveillance qui reçoit en entrée au moins un signal de donnée circulant sur un chemin conducteur et arrivant sur un élément séquentiel de destination, le dispositif de surveillance comprenant :
- des moyens pour définir, à partir de l'arbre d'horloge, au moins une fenêtre de détection ; et
- des moyens de détection d'une transition de chaque signal de donnée reçu pendant une fenêtre de détection ; et
dans lequel chaque fenêtre de détection est définie pour permettre la détection ou l'anticipation d'une faute correspondant à une violation d'un temps d'établissement ou d'un temps de maintien d'un signal de donnée par rapport à un front du signal d'horloge reçu par l'élément séquentiel de destination recevant ce signal de donnée.

Le circuit selon l'invention peut comporter, en plus des caractéristiques principales qui viennent d'être mentionnées dans le paragraphe précédent, une ou plusieurs caractéristiques supplémentaires parmi les suivantes:
- lesdits moyens de détection du dispositif de surveillance détectent une transition de signal sur une même fenêtre de détection pour plusieurs signaux de données reçus arrivant respectivement sur plusieurs éléments séquentiels de destination.
- lesdits moyens pour définir au moins une fenêtre de détection comprennent un circuit générateur qui est inséré dans l'arbre d'horloge, ledit circuit générateur propageant ledit signal d'horloge jusqu'à au moins un élément séquentiel de destination et délivrant au moins un signal temporel permettant la génération d'au moins une fenêtre de détection.
- au moins une fenêtre de détection est variable, lesdits moyens de définition d'une fenêtre de détection recevant au moins un signal de contrôle permettant la définition d'une fenêtre de détection variable.
- au moins une fenêtre de détection est localisée avant un front du signal d'horloge.
- au moins une fenêtre de détection est localisée autour d'un front du signal d'horloge.
- au moins une fenêtre de détection est localisée après un front du signal d'horloge.
- le circuit de surveillance comporte au moins un élément mémoire pour mémoriser au moins une transition détectée avec les moyens de détection de transition.
- le circuit électronique numérique comprend en outre des moyens de réglage de la fréquence du signal d'horloge en fonction des transitions détectées par les moyens de détection de transition.
- le circuit électronique numérique comprend en outre des moyens de réglage de la tension de fonctionnement du circuit et/ou de la tension du substrat en fonction des transitions détectées par les moyens de détection de transition.
- les éléments séquentiels sont des bascules du type passantes sur un front du signal d'horloge.

La présente invention se rapporte également à un dispositif de surveillance du fonctionnement d'un circuit électronique numérique, le dit circuit numérique comportant notamment :
- une pluralité d'éléments séquentiels, notamment de type bascules ;
- une pluralité de chemins conducteurs d'une donnée, chaque chemin de ladite pluralité de chemins reliant deux éléments séquentiels de ladite pluralité d'éléments séquentiels ;
- une horloge délivrant un signal d'horloge, ledit signal d'horloge cadençant notamment les éléments séquentiels ;
   caractérisé en ce que le dispositif de surveillance comporte au moins un circuit de surveillance, ledit circuit de surveillance recevant en entrée :
- un signal de donnée circulant sur un des chemins conducteurs de la pluralité de chemins conducteurs ;
- un signal temporel transmis pour générer une fenêtre variable, dite fenêtre de détection variable, le dit signal temporel présentant une alternance haute de durée inférieure à l'alternance haute du signal d'horloge;
et en ce que le circuit de surveillance comporte des moyens de détection de transition du signal de donnée pendant la fenêtre de détection.

Le dispositif selon l'invention peut comporter, en plus des caractéristiques principales qui viennent d'être mentionnées dans le paragraphe précédent, une ou plusieurs caractéristiques supplémentaires parmi les suivantes:
- le dispositif selon l'invention comporte des moyens pour générer la fenêtre de détection variable en la localisant avant un front du signal d'horloge ;
- le dispositif selon l'invention comporte des moyens pour générer la fenêtre de détection variable en la localisant autour d'un front du signal d'horloge ;
- le dispositif selon l'invention comporte des moyens pour générer la fenêtre de détection variable en la localisant après un front du signal d'horloge ;
- le dispositif selon l'invention comporte des moyens pour générer une pluralité de fenêtres de détection, avec au moins une fenêtre de détection avant un front montant du signal d'horloge, et au moins une fenêtre de détection autour d'un front du signal d'horloge ;
- le circuit de surveillance comporte au moins un élément mémoire pour mémoriser les transitions détectées avec les moyens de détection de transition du signal de donnée pendant la fenêtre de détection ;
- le circuit de surveillance comporte au moins un transistor utilisé pour transmettre le signal temporel aux moyens de détection de transition du signal de donnée dudit circuit de surveillance ;
- le dispositif de surveillance comporte, pour générer au moins le signal temporel transmis sous la forme d'une fenêtre variable, un circuit générateur, ledit circuit générateur comportant notamment un élément combinatoire recevant à une première entrée un premier signal correspondant au signal d'horloge éventuellement retardé, et à une deuxième entrée un deuxième signal, correspondant au premier signal ayant traversé au moins un élément inverseur et/ou au moins un élément de type porte combinatoire non inverseuse ;
- l'élément combinatoire du circuit générateur est du type porte NAND.

Les différentes caractéristiques supplémentaires du dispositif selon l'invention, dans la mesure où elles ne s'excluent pas mutuellement, sont combinées selon toutes les possibilités d'association pour aboutir à différents exemples de mise en oeuvre du procédé selon l'invention.

L'invention et ses différentes applications seront mieux comprises à la lecture de la description qui suit et à l'examen des figures qui l'accompagnent.

Celles-ci ne sont présentées qu'à titre indicatif et nullement limitatif de l'invention.
- la figure 1, illustre de manière schématique un circuit électronique numérique intégrant le dispositif de surveillance selon l'invention ;
- la figure 2 illustre schématiquement une représentation fonctionnelle d'un circuit de surveillance/observation du dispositif de surveillance/observation selon l'invention ;
- la figure 3 illustre différents exemples de réalisation d'un élément de détection de transition du circuit de surveillance/observation du dispositif de surveillance/observation selon l'invention ;
- la figure 4 représente différents chronogrammes de différents signaux intervenant dans un des exemples de circuit de détection de la figure 3 ;
- la figure 5 montre un exemple de réalisation d'un élément de mémoire du circuit de surveillance du dispositif de surveillance selon l'invention ;
- la figure 6 illustre différents exemples de réalisation d'une structure permettant l'insertion de la fenêtre de détection dans le circuit de détection de transition ;
- la figure 7 illustre différents exemples d'utilisation possible du dispositif de surveillance/observation selon l'invention ;
- la figure 8 montre un exemple de réalisation d'un circuit générateur de fenêtre temporelle utilisée dans le dispositif de surveillance selon l'invention.

Les différents éléments apparaissant sur différentes figures auront conservé, sauf précision contraire, les mêmes références.

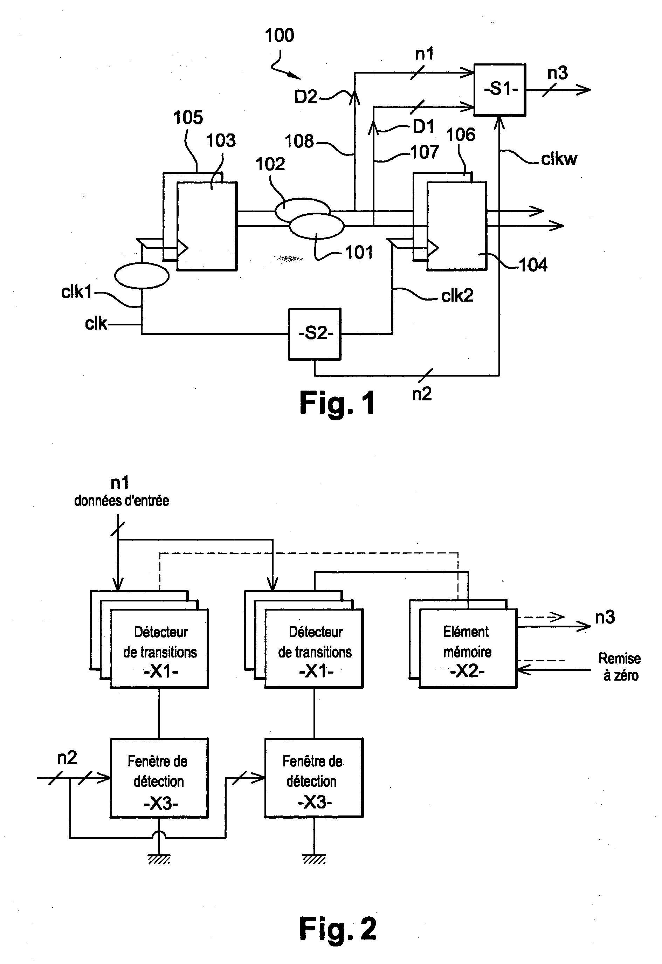

Sur la figure 1, on a représenté schématiquement une partie d'un circuit numérique 100 avec un premier chemin 101 conducteur de données et un deuxième chemin 102 conducteur de données reliant respectivement un premier élément séquentiel d'entrée 103 de type bascule à un premier élément séquentiel de destination 104 de type bascule, et un deuxième élément séquentiel d'entrée 105 de type bascule à un deuxième élément séquentiel de destination 106. Chaque chemin de données est typiquement constitué d'éléments combinatoires, de type portes logiques, qui sont traversés par les données circulant sur les chemins considérés. Selon l'invention, on insère dans le circuit numérique un circuit de détection de transition S1, qui reçoit en entrée des signaux de données D1 et D2 circulant sur le premier chemin 101 et le deuxième chemin 102, respectivement par une première liaison de dérivation 107 et par une deuxième liaison de dérivation. 108. Un premier signal d'horloge Clk est transmis après passage dans une partie de l'arbre d'horloge aux bascules 103 et 105 (clk1), ainsi qu'en parallèle au reste de l'arbre d'horloge puis à un circuit générateur de fenêtres temporelles S2. Le circuit générateur de fenêtres temporelles S2 fournit un deuxième signal d'horloge Clk2 aux bascules 104 et 106, et un signal temporel, consistant en au moins une fenêtre de détection variable au circuit de détection S1. Le dispositif de surveillance selon l'invention est, dans la pratique, essentiellement constitué du circuit de détection S1 et du circuit générateur S2.

Ainsi, comme représenté à la figure 1, le circuit de détection S1 s'insère, dans le circuit numérique 100, au niveau des chemins de données, à proximité des bascules du circuit. Le circuit de détection S1 reçoit comme signaux d'entrée n1 signaux venant de la partie combinatoire (chemins de données) et n2 signaux venant du circuit générateur S2, dont la fonction est de calibrer une ou plusieurs fenêtres temporelles de détection qui seront utilisées par le circuit de détection S1. Le circuit de détection S1 fournit n3 sorties qui sont activées lorsqu'une transition dans un signal de données a été effectivement détectée pendant qu'au moins une fenêtre temporelle de détection était active, comme il le sera décrit plus en détail par la suite.

Le circuit générateur S2 s'insère donc dans le chemin d'horloge du circuit numérique 100. Le circuit générateur S2 peut, d'une façon générale, être localisé n'importe où dans le circuit numérique 100 ; il est cependant préférable de respecter une insertion homogène selon la symétrie de l'arbre d'horloge. Il est également avantageux de disposer le circuit générateur S2 au plus près des bascules, c'est-à-dire en bout de feuille de l'arbre d'horloge, c'est à dire à proximité du circuit de détection S1 afin d'éviter l'introduction de problèmes de décalage des temps d'arrivée du signal d'horloge au bout des différentes feuilles de l'arbre (skew).

S2 prend en entrée le signal d'horloge, et génère un ou plusieurs signaux clkw permettant de calibrer le(s) fenêtre(s) de détection et envoyant les signaux sur S1, tout en continuant d'amener l'horloge à sa destination. S2 peut également prendre des signaux de contrôle permettant de choisir les fenêtres de détection à envoyer via les fils n2.

Comme illustré schématiquement à la figure 2, le circuit de détection S1 fonctionne selon le principe connu dit de XOR par déchargement de la capacité d'entrée de la porte suivante. Il est ainsi composé des éléments suivants :
- des moyens de détection de transition, également désignés comme détecteurs de transition, X1 ; on compte, selon l'invention, autant de détecteurs de transition X1 que le circuit de détection S1 admet de signaux d'entrée, n1 dans l'exemple représenté ;
- au moins un élément de mémoire X2, au nombre de n3 - n3 étant également le nombre de bits de sortie du circuit de détection de transition S1
- dans l'exemple représenté, dont la fonction est de mémoriser une information sur les transitions détectées dans les signaux de données pendant l'activation des fenêtres temporelles ; chaque élément de mémoire peut également admettre en entrée un signal de contrôle externe apte à vider le contenu de la mémoire considérée ;
- au moins un élément X3, au nombre de n2 dans l'exemple représenté, d'insertion de la fenêtre de détection de transition, pour l'insertion de la fenêtre de détection dans le circuit de détection S1 au niveau des détecteurs de transition X1. Il faut noter qu'il y a autant de bits de sortie du circuit de détection de transition S1 qu'il y a de fenêtres de détection X3 activées à la fois.

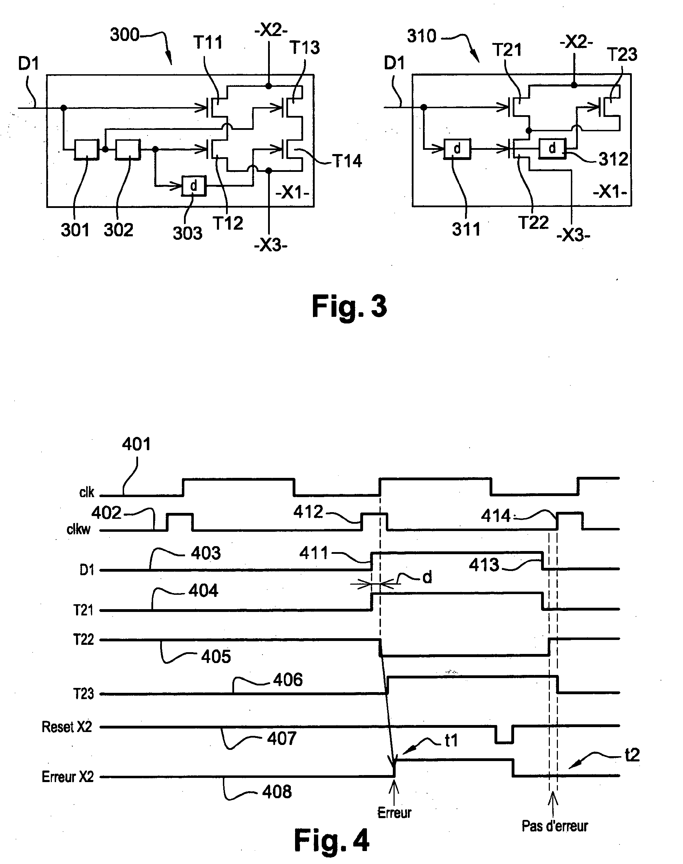

La figure 3 illustre deux exemples de réalisation d'un détecteur de transition X1.

Un premier exemple 300 de réalisation présente l'architecture suivante :
- un premier transistor à effet de champ (FET) (canal N) T11 reçoit sur sa grille un signal de donnée D1 ; le drain du FET T11 est relié à un élément de mémoire X2 ;
- un deuxième FET canal N T12 reçoit également sur sa grille le signal D1 après passage par un premier délai inverseur 301 et un délai non inverseur 302 ; la fonction d'un délai total inverseur est de retarder un signal et de l'inverser ; les délais inverseurs sont par exemple élaborés au moyen de cellules logiques ; le drain du FET T12 est relié à la source du FET T11 ;
- un troisième FET canal N T 13 reçoit sur sa grille le signal D1 après passage par le premier délai inverseur 301 ; le drain du FET T13 est relié à l'élément de mémoire X2 ;
- un quatrième FET canal N reçoit sur sa grille le signal D1 après un passage par le délai inverseur 301, le délai non inverseur 302 et par un délai inverseur 303 ; le drain du FET T14 est relié à la source du FET T12 ;
- la source du FET T12 et la source du FET T14 sont reliées à un élément X3.

Un deuxième exemple 310 de réalisation présente l'architecture suivante :
- un premier FET canal N T21 reçoit sur sa grille un signal de donnée D1 ; le drain du FET T21 est relié à un élément de mémoire X2 ;
- un deuxième FET canal N T22 reçoit également sur sa grille le signal D1 après passage par un premier délai inverseur 311 ; le drain du FET T22 est relié à la source du FET T21 ;
- un troisième FET canal N T 23 reçoit sur sa grille le signal D1 après un passage par le premier délai inverseur 311 et par un deuxième délai inverseur 312; le drain du FET T23 est relié à l'élément de mémoire X2 ; la source du FET T23 est reliée au drain du FET T22 ;
- la source du FET T22 est reliée à un élément X3.

Ainsi, d'une manière générale, le détecteur de transition X1 prend en entrée les données arrivant en avant de la bascule et détecte les fronts montants ou descendants. Il est, dans les exemples décrits, simplement composé de transistors N permettant la décharge de la capacité d'entrée de la porte de connexion contenue dans X2, élément mémoire permettant de sauvegarder la valeur de décharge et délivrant un signal 0 ou un 1 selon la polarité souhaitée. On notera que bien évidemment une structure tout à fait équivalente peut être faite en logique duale à base de transistors PMOS, voire avec une combinaison de NMOS et PMOS.

Dans le cas de plusieurs entrées, la structure du détecteur de transition X1 est répétée en parallèle autant de fois qu'il y a de signal de données d'entrée. On notera également qu'une structure similaire peut aussi être implémentée en logique dynamique, reprenant tous les éléments du détecteur de transition X1 (sur une ou plusieurs entrées), associé à un module X2 qui précharge la sortie de X1 pendant la phase d'horloge où celui-ci n'est pas évalué et génère un signal pouvant être mémorisé à plus haut niveau.

Au moyen des chronogrammes de la figure 4, on explique à présent comment le deuxième exemple de réalisation 310 permet de réaliser une détection de transition du signal de donnée D1.

Sur cette figure :
- un premier chronogramme 401 illustre l'évolution temporelle du signal d'horloge clk du circuit numérique 100 ;
- un deuxième chronogramme 402 illustre l'évolution temporelle de la fenêtre de détection clkw ;
- un troisième chronogramme 403 illustre l'évolution temporelle du signal de donnée D1 ;
- un quatrième chronogramme 404 illustre l'évolution temporelle du caractère passant/bloqué du premier FET T21;
- un cinquième chronogramme 405 illustre l'évolution temporelle du caractère passant/bloqué du deuxième FET T22;
- un sixième chronogramme 406 illustre l'évolution temporelle du caractère passant/bloqué du troisième FET T23;
- un septième chronogramme 407 illustre l'évolution d'un signal de réinitialisation de l'élément de mémoire X2 ;
- un huitième chronogramme 408 illustre l'évolution de l'information d'erreur mémorisée dans l'élément de mémoire X2 dans le cas où la polarité choisie est telle qu'il y ait détection quand le paramètre "erreur" prend la valeur "1 " .

Dans l'exemple représenté, selon l'architecture du deuxième exemple 310, il y a décharge à l'entrée de l'élément de mémoire X2 si une des deux combinaisons suivantes est observée :
- la fenêtre de détection est active (le signal clkw est à la valeur binaire 1), et les FET 21 et 22 sont passants ; on détecte alors une transition de 0 à 1 du signal de donnée D1 ;
- la fenêtre de détection est active, et les FET 23 et 22 sont passants ; on détecte alors une transition de 1 à 0 du signal de donnée D1.

Ainsi, les chronogrammes représentés correspondent au cas où une erreur a été détectée à un instant t1, la donnée D1 arrivant (front montant 411) au niveau de la bascule après le front montant de la fenêtre de détection (front montant 412). Une telle observation permet d'affirmer que le chemin parcouru par D1 est trop long par rapport à la fréquence d'horloge utilisée. La fréquence d'horloge devra en conséquence être diminuée.

A l'inverse, à un instant t2, qui suit directement le passage du signal de donnée de la valeur 1 à la valeur 0, aucune erreur n'est détectée, le signal de donnée D1 présentant un front descendant 413 arrivant suffisamment avant une nouvelle fenêtre de détection repérée par un front montant 414. Le chemin emprunté ici par la donnée D1 est plus court que le précédent chemin qui a provoqué l'erreur à l'instant t1.

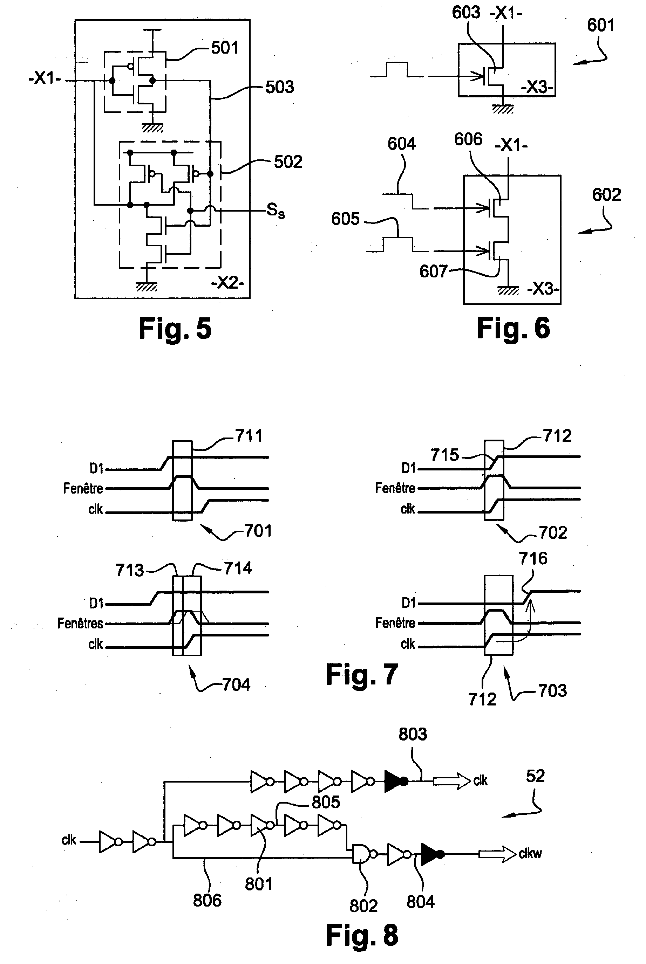

La figure 5 illustre un exemple de réalisation d'un élément de mémoire X2. L'élément de mémoire X2 est dans cet exemple constitué d'un circuit inverseur 501 et d'un circuit logique de type NAND 502, ce dernier permettant la conservation en mémoire d'une information d'erreur détectée. Le signal issu du détecteur de transition X1 est transmis à la fois au circuit inverseur 501 et au circuit logique de type NAND 502, ces deux circuits étant par ailleurs reliés entre eux par une liaison 503.

Ainsi, d'une manière générale, l'élément de mémoire X2 garde la valeur de détection de transition, avantageusement pour la transmettre à plus haut niveau dans un système global incorporant le dispositif de surveillance selon l'invention ; le module de mémoire X2 peut avantageusement être remis à zéro grâce à un signal spécifique Ss transmis au circuit logique de type NAND 502. L'élément de mémoire X2 peut bien évidemment être implémenté de manières très diverses (verrou, inverseur + bascule, ...).

Afin de discrétiser les informations provenant de fenêtres temporelles différentes, il convient d'avoir autant d'éléments mémoire X2 que de fenêtres temporelles créées provenant du circuit générateur de fenêtres temporelles S2.

La figure 6 illustre différents exemples de réalisation d'une structure X3 permettant l'insertion de la fenêtre de détection dans le circuit de détection de transition. Le rôle de la structure X3 dans le circuit de détection de transition S1 est de permettre la décharge d'un signal révélateur d'une transition d'un signal de donnée si et seulement si la fenêtre de détection est active. Selon un premier mode de réalisation de la structure X3, correspondant au cas où un unique pulse produit par le circuit générateur S2 est suffisant pour couvrir la fenêtre désirée, un unique transistor 603 est nécessaire. Selon un deuxième mode de réalisation de la structure X3, correspondant au cas où le circuit générateur S2 produit un premier signal 605 destiné à ouvrir la fenêtre de détection, et un deuxième signal 604, destiné à fermer la fenêtre de détection, il est nécessaire d'utiliser un premier transistor 606 et un deuxième transistor 607, par exemple des transistors FET de type N, la source du premier transistor 606 étant reliée au drain du deuxième transistor 607, les signaux générés par le circuit générateur étant reçus par les grilles des deux transistors. De plus, il est tout à fait possible d'inclure de la logique de contrôle avant ou intégrée à la structure X3 permettant l'activation ou non du système de capteur.

Le dispositif de surveillance selon l'invention peut être utilisé selon différents modes, notamment ceux illustrés à la figure 7.

Dans un premier mode d'utilisation 701, le dispositif est utilisé en anticipateur de fautes en localisant une fenêtre de détection 711 avant le front montant du signal d'horloge.

Dans un deuxième mode d'utilisation 702 et 703, le dispositif est utilisé en détecteur de fautes en localisant une fenêtre de détection 712 autour du front montant du signal d'horloge. Dans le premier cas 702, une faute est détectée, le signal de donnée D1 présentant un front montant 715 pendant la fenêtre de détection 712. Dans le deuxième cas 703, aucune faute n'est détectée, le signal de donnée D1 présentant un front montant 716 après la fenêtre de détection 712 ; ces différents cas de figure ont été détaillés en référence à la figure 4.

Dans un troisième mode d'utilisation 704, le dispositif est utilisé en discriminateur d'avertissement de fautes en générant plusieurs fenêtres de détection, par exemple une première fenêtre 713 et une deuxième fenêtre 714, localisées respectivement avant et sur le front d'horloge. Dans l'invention, lorsqu'il y a plusieurs fenêtres de détection, les signaux associés auxdites fenêtres peuvent être indépendamment générés puis propagés par le circuit générateur S2, ou bien être créés en interne du circuit de détection de transition S1 à partir de signaux de départ grâce à l'introduction de délais dans le circuit S1 ; dans le deuxième cas de figure, on limite le nombre de fils conducteurs présents en entrée du circuit S1.

La figure 8 illustre un exemple de réalisation d'un circuit générateur S2 dont la fonction est de propager, au niveau d'une première branche 803, un signal d'horloge clk de qualité aux bascules tout en générant, au niveau d'une deuxième branche 804, à partir de ce même signal d'horloge clk les éléments nécessaires à la constitution des fenêtres de détection clkw. A cet effet, on propose, dans l'invention, d'utiliser les temps de propagation du signal d'horloge, notamment au travers d'éléments de type inverseurs, pour pouvoir bien calibrer et ajuster la fenêtre de détection et le signal d'horloge.

Ainsi, dans l'exemple illustré, on implémente, pour former un chemin long, une succession d'inverseurs 801 et de buffers sur une première liaison 805 de la deuxième branche 804, le nombre d'inverseurs et de buffers dépendant notamment des variations de retard observées avec les variations de l'alimentation ou de la température. La génération de la fenêtre de détection se fait par la présence d'une porte NAND 802 recevant en entrée d'une part la première liaison 805 et d'autre part une deuxième liaison 806 de la deuxième branche 804 véhiculant le signal d'horloge clk, ladite deuxième liaison formant un chemin court. Ainsi, on obtient une fenêtre de détection présentant une alternance haute de durée inférieure à l'alternance haute du signal d'horloge.

Le dispositif de surveillance selon l'invention, outre son rôle d'anticipation des violations des contraintes temporelles, offre ainsi une grande résolution temporelle, tout en évitant l'ajout de buffers pour combler les éventuelles fautes de temps de maintien des bascules disposées sur différents chemins. La détection en ligne de la criticité de signaux est avantageusement utilisée pour asservir la fréquence d'horloge et/ou la tension de fonctionnement et/ou la tension de substrat afin de maintenir la fonction numérique dans une zone de fonctionnement fiable et optimale.

## Revendications

1. Circuit électronique numérique (100) comprenant :
- une pluralité d'éléments séquentiels (103 ; 104 ; 105 ; 106) ;
- au moins un chemin conducteur de données (101 ; 102) reliant un élément séquentiel d'entrée à un élément séquentiel de destination ;
- une horloge délivrant un signal d'horloge (clk) sur un arbre d'horloge pour cadencer les éléments séquentiels ;
**caractérisé en ce qu'**il comprend un dispositif de surveillance (S1; S2) qui reçoit en entrée au moins un signal de donnée (D1, D2) circulant sur un chemin conducteur et arrivant sur un élément séquentiel de destination, le dispositif de surveillance comprenant :
- des moyens (S2 ; X3) pour définir, à partir de l'arbre d'horloge, au moins une fenêtre de détection ; et
- des moyens (X1) de détection d'une transition de chaque signal de donnée reçu pendant une fenêtre de détection ; et
dans lequel chaque fenêtre de détection est définie pour permettre la détection ou l'anticipation d'une faute correspondant à une violation d'un temps d'établissement ou d'un temps de maintien d'un signal de donnée par rapport à un front du signal d'horloge reçu par l'élément séquentiel de destination recevant ce signal de donnée.

2. Circuit électronique selon la revendication 1, dans lequel lesdits moyens de détection du dispositif de surveillance détectent une transition de signal sur une même fenêtre de détection pour plusieurs signaux de données reçus arrivant respectivement sur plusieurs éléments séquentiels de destination.

3. Circuit électronique selon l'une des revendications précédentes, dans lequel lesdits moyens pour définir au moins une fenêtre de détection comprennent un circuit générateur (S2) qui est inséré dans l'arbre d'horloge, ledit circuit générateur propageant ledit signal d'horloge jusqu'à au moins un élément séquentiel de destination et délivrant au moins un signal temporel (clkw) permettant la génération d'au moins une fenêtre de détection.

4. Circuit selon l'une des revendications précédentes, dans lequel au moins une fenêtre de détection est variable, lesdits moyens de définition d'une fenêtre de détection recevant au moins un signal de contrôle permettant la définition d'une fenêtre de détection variable.

5. Circuit selon l'une des revendications précédentes **caractérisé en ce qu'**au moins une fenêtre de détection (711) est localisée avant un front du signal d'horloge.

6. Circuit selon l'une des revendications 1 à 4, **caractérisé en ce qu'**au moins une fenêtre de détection (712) est localisée autour d'un front du signal d'horloge.

7. Circuit selon l'une des revendications 1 à 4, **caractérisé en ce qu'**au moins une fenêtre de détection est localisée après un front du signal d'horloge.

8. Circuit selon l'une au moins des revendications précédentes **caractérisé en ce que** le circuit de surveillance comporte au moins un élément mémoire (X2) pour mémoriser au moins une transition détectée avec les moyens de détection (X1) de transition.

9. Circuit selon la revendication 5, comprenant en outre des moyens de réglage de la fréquence du signal d'horloge en fonction des transitions détectées par les moyens de détection de transition (X1).

10. Circuit selon la revendication 7, comprenant en outre des moyens de réglage de la tension de fonctionnement du circuit et/ou de la tension du substrat en fonction des transitions détectées par les moyens de détection de transition (X1).

11. Circuit selon l'une des revendications précédentes, dans lequel les éléments séquentiels sont des bascules du type passantes sur un front du signal d'horloge.

## Patentansprüche

1. Digitaler elektronischer Schaltkreis (100) bestehend aus:
- einer Mehrzahl sequentieller Elemente (103; 104; 105; 106);
- mindestens einem Datenleiterpfad (101; 102), der ein sequentielles Eingangselement mit einem sequentiellen Zielelement verbindet;
- einem Taktgeber, der ein Taktsignal (clk) an eine Taktgeberwelle liefert, um die sequentiellen Elemente zu takten;
**dadurch gekennzeichnet, dass** er eine Überwachungsvorrichtung (S1; S2) umfasst, die eingangs mindestens ein Datensignal (D1, D2) empfängt, das auf einem Leiterpfad läuft und auf einem sequentiellen Zielelement ankommt, wobei die Sicherheitsvorrichtung aus den folgenden Mitteln besteht:
- Mittel (S2; X3) zum Definieren, ab der Taktgeberwelle, mindestens eines Meldefensters; und
- Meldungsmittel (X1) einer Transition jedes während eines Meldefensters empfangenen Datensignals; und
bei der jedes Meldefenster derart definiert ist, dass ein Fehler gemeldet oder verhütet werden kann, der einer Verletzung einer Herstellungszeit oder einer Haltezeit eines Datensignals in Bezug auf eine Front des vom sequentiellen Zielelement empfangenen Taktsignals entspricht, das dieses Datensignal empfängt.

2. Elektronischer Schaltkreis gemäß Anspruch 1, bei dem die genannten Meldemittel der Überwachungsvorrichtung eine Signaltransition meldet, in einem selben Meldefenster für mehrere empfangene Datensignale, die jeweils an mehreren sequentiellen Zielelementen eintreffen.

3. Elektronischer Schaltkreis gemäß einem der vorangehenden Ansprüche, bei dem die genannten Mittel zum Definieren mindestens eines Meldefensters einen Erzeugerschaltkreis (S2) aufweisen, der in der Taktgeberwelle eingefügt ist, wobei der Erzeugerschaltkreis das genannte Taktsignal bis an das mindestens eine sequentielle Zielelement leitet und mindestens ein Zeitsignal (clkw) liefert, das die Erzeugung mindestens eines Meldefensters ermöglicht.

4. Schaltkreis gemäß einem der vorangehenden Ansprüche, bei dem mindestens ein Meldefenster variabel ist, wobei die Definitionsmittel eines Meldefensters mindestens ein Steuersignal erhalten, das die Definition eines variablen Meldefensters ermöglicht.

5. Schaltkreis gemäß einem der vorangehenden Ansprüche, **dadurch gekennzeichnet, dass** mindestens ein Meldefenster (711) vor einer Front des Taktsignals angeordnet ist.

6. Schaltkreis gemäß einem der Ansprüche 1 bis 4, **dadurch gekennzeichnet, dass** mindestens ein Meldefenster (712) um eine Front des Taktsignals herum angeordnet ist.

7. Schaltkreis gemäß einem der Ansprüche 1 bis 4, **dadurch gekennzeichnet, dass** mindestens ein Meldefenster hinter einer Front des Taktsignals angeordnet ist.

8. Schaltkreis gemäß mindestens einem der vorangehenden Ansprüche, **dadurch gekennzeichnet, dass** die Überwachungsschaltung mindestens ein Speicherelement (X2) umfasst, um mindestens eine anhand der Transitionsmeldemittel (X1) gemeldete Transition zu speichern.

9. Schaltkreis gemäß Anspruch 5, der ferner Mittel zur Einstellung der Frequenz des Taktsignals entsprechend den von den Transitionsmeldemitteln (X1) gemeldeten Transitionen umfasst.

10. Schaltkreis gemäß Anspruch 7, der ferner Mittel zur Einstellung der Betriebsspannung des Schaltkreises und/oder der Spannung des Substrats entsprechend den von den Transitionsmeldemitteln (X1) gemeldeten Transitionen umfasst.

11. Schaltkreis gemäß einem der vorangehenden Ansprüche, bei dem die sequentiellen Elemente Kippschaltungen vom Typ durchlässig an einer Front des Taktsignals sind.

## Claims

1. Digital electronic circuit (100) including:
- a plurality of sequential elements (103; 104; 105; 106);
- at least one data conducting path (101; 102) connecting an input sequential element to a destination sequential element;
- a clock outputting a clock signal (clk) on a clock tree for setting the speed of the sequential elements;
**characterised in that** said circuit includes a monitoring device (S1; S2) receiving, as an input, at least one data signal (D1, D2) travelling on a conducting path and arriving at a destination sequential element, the monitoring device including:
- a means (S2; X3) for defining at least one detection window according to the clock tree; and
- a means (X1) for detecting a transition of each data signal received during a detection window; and
wherein each detection window is defined so as to enable the detection or anticipation of a fault corresponding to a violation of a rise time or a maintenance time of a data signal relative to a clock signal edge received by the destination sequential element receiving said data signal.

2. Electronic circuit according to claim 1, wherein said detecting means of the monitoring device detect a signal transition on a same detection window for several received data signals arriving respectively at several destination sequential elements.

3. Electronic circuit according to one of the preceding claims, wherein said means for defining at least one detection window include a generating circuit (S2) which is inserted into the clock tree, said generating circuit propagating said clock signal up to at least one destination sequential element and outputting at least one time signal (clkw) enabling the generation of at least one detection window.

4. Circuit according to one of the preceding claims, wherein at least one detection window is variable, said means for defining a detection window receiving at least one control signal enabling the definition of a variable detection window.

5. Circuit according to one of the preceding claims **characterised in that** at least one detection window (711) is located before a clock signal edge.

6. Circuit according to one of claims 1 to 4, **characterised in that** at least one detection window (712) is located around a clock signal edge.

7. Circuit according to one of claims 1 to 4, **characterised in that** at least one detection window is located after a clock signal edge.

8. Circuit according to at least one of the preceding claims **characterised in that** the monitoring circuit includes at least one memory element (X2) to memorise at least one transition detected with the transition detection means (X1).

9. Circuit according to claim 5, further including a means for adjusting the frequency of the clock signal as a function of the transitions detected by the transition detection means (X1).

10. Circuit according to claim 7, further including a means for adjusting the operating voltage of the circuit and/or the voltage of the substrate as a function of the transitions detected by the transition detection means (X1).

11. Circuit according to one of the preceding claims, wherein the sequential elements are passing type flip flops on a clock signal edge.
